# EUROPEAN PATENT APPLICATION

(11) **EP 4 582 947 A1**
(43) Date of publication of application: **09.07.2025**
(21) Application number: 23869769.2
(22) Date of filing: 26.06.2023
(51) Int. Cl.: G06F 9/50, G11C 11/406

(54) **MEMORY REFRESH METHOD AND APPARATUS**

(30) Priority: 26.09.2022 CN 202211171751
(71) Applicant: Huawei Technologies Co., Ltd., Shenzhen, Guangdong 518129 (CN)
(72) Inventor: LIU, Zhenjun, Shenzhen, Guangdong 518129 (CN); LIANG, Chuanzeng, Shenzhen, Guangdong 518129 (CN); QIAN, Erqing, Shenzhen, Guangdong 518129 (CN); GUO, Wei, Shenzhen, Guangdong 518129 (CN)
(74) Representative: Goddar, Heinz J.
(86) International application number: PCT/CN2023/102312
(87) International publication number: WO 2024/066521

(57) **Abstract**

Embodiments of this application relate to the field of computer technologies, and disclose a memory refresh method and apparatus, to reduce power consumption of a memory. The method includes: obtaining target information of a rank, and then determining a memory refresh mode of the rank from a plurality of memory refresh modes based on the target information. The target information indicates a quantity of commands or traffic of the rank, and power consumption of the rank varies in the plurality of memory refresh modes.

## Description

This application claims priority to Chinese Patent Application No. 202211171751.0, filed with the China National Intellectual Property Administration on September 26, 2022 and entitled "MEMORY REFRESH METHOD AND APPARATUS", which is incorporated herein by reference in its entirety.

### TECHNICAL FIELD

Embodiments of this application relate to the field of computer technologies, and in particular, to a memory refresh method and apparatus.

### BACKGROUND

A memory (Memory) is an important component of an electronic device, and the memory is configured to temporarily store computational data in a central processing unit (central processing unit, CPU) of the electronic device and data exchanged with an external memory of the electronic device.

When the electronic device runs an application (application, APP), to-be-computed data needs to be transferred from the memory to the CPU for computation. When computation is completed, the CPU conveys a computation result.

In recent years, with an increase in functions of the app, computational data to be computed by the CPU also increases accordingly, and a data amount of memory swapping and power consumption of the memory also increase accordingly. Therefore, how to reduce the power consumption of the memory is one of urgent problems that need to be resolved by a person skilled in the art.

### SUMMARY

Embodiments of this application provide a memory refresh method and apparatus, to reduce power consumption of a memory. To achieve the foregoing objectives, the following technical solutions are used in embodiments of this application.

According to a first aspect, an embodiment of this application provides a memory refresh method. The method includes: obtaining target information of a rank, and then determining a memory refresh mode of the rank from a plurality of memory refresh modes based on the target information. The target information indicates a quantity of commands or traffic of the rank, and power consumption of the rank in the plurality of memory refresh modes is different.

It can be learned that, according to the memory refresh method provided in this embodiment of this application, the memory refresh mode of the rank can be dynamically switched between the plurality of memory refresh modes (for example, an all bank refresh (All Bank Refresh, ABR) mode and a per bank refresh (Per Bank Refresh, PBR) mode) with different power consumption based on the quantity of commands or the traffic of the rank. Compared with that in a related technology in which a memory is refreshed only in a high-power-consumption refresh mode, in the method provided in this embodiment of this application, a memory refresh mode of the memory is dynamically switched based on the quantity of commands or the traffic of the rank, so that power consumption of the memory can be reduced.

In a possible implementation, the quantity of commands includes at least one of a quantity of commands at an entry of a memory controller, a quantity of commands in a queue in the memory controller, or a quantity of commands on a memory interface.

It may be understood that, the quantity of commands of the rank may be reflected by the quantity of commands of the rank at the entry of the memory controller, the quantity of commands of the rank in the queue in the memory controller, or the quantity of commands of the rank on the memory interface, and the memory refresh mode of the memory can be dynamically switched based on the data, so that the power consumption of the memory can be reduced.

For example, the target information of the rank may include the quantity of commands of the rank at the entry of the memory controller.

For another example, the target information of the rank may include the quantity of commands of the rank in the queue in the memory controller.

For another example, the target information of the rank may include the quantity of commands of the rank on the memory interface.

Optionally, the plurality of memory refresh modes may include a first memory refresh mode and a second memory refresh mode.

For example, the plurality of memory refresh modes may include the ABR mode and the PBR mode.

In a possible implementation, it may be determined, based on the target information, that the memory refresh mode of the rank is the first memory refresh mode or the second memory refresh mode.

It can be learned that, according to the memory refresh method provided in this embodiment of this application, the memory refresh mode of the rank can be dynamically switched between the first memory refresh mode and the second memory refresh mode with different power consumption based on the quantity of commands or the traffic of the rank. Compared with that in a related technology in which a memory is refreshed only in a high-power-consumption refresh mode, in the method provided in this embodiment of this application, a memory refresh mode of the memory is dynamically switched based on the quantity of commands or the traffic of the rank, so that the power consumption of the memory can be reduced.

For example, it may be determined, based on the quantity of commands of the rank at the entry of the memory controller, that the memory refresh mode of the rank is ABR or PBR.

In a possible implementation, when the quantity of commands of the rank is greater than a first quantity threshold or the traffic is greater than a first traffic threshold, it may be determined that the memory refresh mode of the rank is the first memory refresh mode. When the quantity of commands of the rank is less than the first quantity threshold or the traffic is less than the first traffic threshold, it is determined that the memory refresh mode of the rank is the second memory refresh mode.

It may be understood that, if the quantity of commands of the rank is greater than the first quantity threshold or the traffic is greater than the first traffic threshold, it indicates that a data amount of memory swapping of the rank is large. Therefore, the memory refresh mode of the rank may be adjusted to the first memory refresh mode with higher power consumption, to improve memory swapping efficiency of the rank. However, if the quantity of commands of the rank is less than the first quantity threshold or the traffic is less than the first traffic threshold, it indicates that a data amount of memory swapping of the rank is small. Therefore, the memory refresh mode of the rank may be adjusted to the second memory refresh mode with lower power consumption, to reduce the power consumption of the rank.

For example, when the quantity of commands of the rank is greater than a first quantity threshold or the traffic is greater than a first traffic threshold, it may be determined that the memory refresh mode of the rank is ABR.

For another example, when the quantity of commands of the rank is less than the first quantity threshold or the traffic is less than the first traffic threshold, it may be determined that the memory refresh mode of the rank is PBR.

In a possible implementation, performance of the rank in the first memory refresh mode is higher than performance of the rank in the second memory refresh mode.

For example, memory bandwidth of the rank in the first memory refresh mode is greater than memory bandwidth of the rank in the second memory refresh mode.

For another example, a delay of the rank for a command in the first memory refresh mode is lower than a delay of the rank for a command in the second memory refresh mode.

It can be learned that, according to the memory refresh method provided in this embodiment of this application, the memory refresh mode of the rank can be dynamically switched between the plurality of memory refresh modes with different performance based on the quantity of commands or the traffic of the rank. Compared with that in a related technology in which a memory is refreshed only in a low-performance memory refresh mode, in the method provided in this embodiment of this application, a memory refresh mode of the memory is dynamically switched based on the quantity of commands or the traffic of the rank, so that performance of the memory can be improved. Compared with that in a related technology in which the memory is refreshed only in a high-performance memory refresh mode, in the method provided in this embodiment of this application, the memory refresh mode of the memory is dynamically switched based on the quantity of commands or the traffic of the rank, so that power consumption of the memory can be reduced.

In a possible implementation, it may be determined, based on the target information, that the memory refresh mode of the rank is a first memory refresh mode, a second memory refresh mode, or a third memory refresh mode.

It can be learned that, according to the memory refresh method provided in this embodiment of this application, the memory refresh mode of the rank can be dynamically switched among the first memory refresh mode, the second memory refresh mode, and the third memory refresh mode with different power consumption based on the quantity of commands or the traffic of the rank. Compared with that in a related technology in which the memory is refreshed only in a high-power-consumption refresh mode, in the method provided in this embodiment of this application, the memory refresh mode of the memory is dynamically switched based on the quantity of commands or the traffic of the rank, so that the power consumption of the memory can be reduced.

For example, it may be determined, based on the quantity of commands of the rank at the entry of the memory controller, that the memory refresh mode of the rank is ABR, PBR, or same bank refresh (Same Bank Refresh, SBR).

Optionally, power consumption of the rank in the first memory refresh mode is higher than power consumption of the rank in the second memory refresh mode, and the power consumption of the rank in the second memory refresh mode is higher than power consumption of the rank in the third memory refresh mode.

In a possible implementation, when the quantity of commands of the rank is greater than a first quantity threshold or the traffic is greater than a first traffic threshold, it is determined that the memory refresh mode of the rank is the first memory refresh mode.

In a possible implementation, when the quantity of commands of the rank is less than the first quantity threshold and greater than a second quantity threshold, it is determined that the memory refresh mode of the rank is the second memory refresh mode.

In a possible implementation, when the traffic of the rank is less than the first traffic threshold and greater than a second traffic threshold, it is determined that the memory refresh mode of the rank is the second memory refresh mode.

In a possible implementation, when the quantity of commands of the rank is less than the second quantity threshold or the traffic is less than the second traffic threshold, it is determined that the memory refresh mode of the rank is the third memory refresh mode.

It may be understood that, if the quantity of commands of the rank is greater than the first quantity threshold or the traffic is greater than the first traffic threshold, it indicates that a data amount of memory swapping of the rank is large. Therefore, the memory refresh mode of the rank may be adjusted to the first memory refresh mode with higher power consumption, to improve memory swapping efficiency of the rank.

However, if the traffic of the rank is less than the first traffic threshold and greater than the second traffic threshold, or the traffic of the rank is less than the first traffic threshold and greater than the second traffic threshold, it indicates that a data amount of memory swapping of the rank is at a medium level. Therefore, the memory refresh mode of the rank may be adjusted to the second memory refresh mode with medium-level power consumption, to balance memory swapping efficiency and power consumption.

However, if the quantity of commands of the rank is less than the second quantity threshold or the traffic is less than the second traffic threshold, it indicates that a data amount of memory swapping of the rank is small. Therefore, the memory refresh mode of the rank may be adjusted to the third memory refresh mode with lower power consumption, to reduce the power consumption of the rank.

Optionally, performance of the rank in the first memory refresh mode is higher than performance of the rank in the second memory refresh mode, and the performance of the rank in the second memory refresh mode is higher than performance of the rank in the third memory refresh mode.

It can be learned that, according to the memory refresh method provided in this embodiment of this application, the memory refresh mode of the rank can be dynamically switched between the plurality of memory refresh modes with different performance based on the quantity of commands or the traffic of the rank. Compared with that in a related technology in which a memory is refreshed only in a low-performance memory refresh mode, in the method provided in this embodiment of this application, a memory refresh mode of the memory is dynamically switched based on the quantity of commands or the traffic of the rank, so that performance of the memory can be improved. Compared with that in a related technology in which the memory is refreshed only in a high-performance memory refresh mode, in the method provided in this embodiment of this application, the memory refresh mode of the memory is dynamically switched based on the quantity of commands or the traffic of the rank, so that power consumption of the memory can be reduced.

For example, memory bandwidth of the rank in the first memory refresh mode is greater than memory bandwidth of the rank in the second memory refresh mode. Memory bandwidth of the rank in the second memory refresh mode is greater than memory bandwidth of the rank in the third memory refresh mode.

For another example, a delay of the rank for a command in the first memory refresh mode is lower than a delay of the rank for a command in the second memory refresh mode. The delay of the rank for a command in the second memory refresh mode is less than a delay of the rank for a command in the third memory refresh mode.

According to a second aspect, an embodiment of this application provides a memory refresh apparatus. The memory refresh apparatus includes a transceiver unit and a processing unit. The transceiver unit is configured to obtain target information of a rank, and the target information indicates a quantity of commands or traffic of the rank. The processing unit is configured to determine a memory refresh mode of the rank from a plurality of memory refresh modes based on the target information, and power consumption of the rank in the plurality of memory refresh modes is different.

Optionally, the quantity of commands includes at least one of a quantity of commands at an entry of a memory controller, a quantity of commands in a queue in the memory controller, or a quantity of commands on a memory interface.

Optionally, the plurality of memory refresh modes include a first memory refresh mode and a second memory refresh mode.

In a possible implementation, the processing unit is specifically configured to determine, based on the target information, that the memory refresh mode of the rank is the first memory refresh mode or the second memory refresh mode.

Optionally, power consumption of the rank in the first memory refresh mode is higher than power consumption of the rank in the second memory refresh mode.

In a possible implementation, the processing unit is specifically configured to: when the quantity of commands of the rank is greater than a first quantity threshold or the traffic is greater than a first traffic threshold, determine that the memory refresh mode of the rank is the first memory refresh mode; or when the quantity of commands of the rank is less than the first quantity threshold or the traffic is less than the first traffic threshold, determine that the memory refresh mode of the rank is the second memory refresh mode.

Optionally, performance of the rank in the first memory refresh mode is higher than performance of the rank in the second memory refresh mode.

Optionally, the plurality of memory refresh modes include a first memory refresh mode, a second memory refresh mode, and a third memory refresh mode.

In a possible implementation, the processing unit is specifically configured to determine, based on the target information, that the memory refresh mode of the rank is the first memory refresh mode, the second memory refresh mode, or the third memory refresh mode.

Optionally, power consumption of the rank in the first memory refresh mode is higher than power consumption of the rank in the second memory refresh mode, and the power consumption of the rank in the second memory refresh mode is higher than power consumption of the rank in the third memory refresh mode.

In a possible implementation, when the quantity of commands of the rank is greater than a first quantity threshold or the traffic is greater than a first traffic threshold, it is determined that the memory refresh mode of the rank is the first memory refresh mode. When the quantity of commands of the rank is less than the first quantity threshold and greater than a second quantity threshold, it is determined that the memory refresh mode of the rank is the second memory refresh mode. When the traffic of the rank is less than the first traffic threshold and greater than a second traffic threshold, it is determined that the memory refresh mode of the rank is the second memory refresh mode. When the quantity of commands of the rank is less than the second quantity threshold or the traffic is less than the second traffic threshold, it is determined that the memory refresh mode of the rank is the third memory refresh mode.

Optionally, performance of the rank in the first memory refresh mode is higher than performance of the rank in the second memory refresh mode, and the performance of the rank in the second memory refresh mode is higher than performance of the rank in the third memory refresh mode.

According to a third aspect, an embodiment of this application further provides a memory refresh apparatus. The memory refresh apparatus includes at least one processor. When executing program code or instructions, the at least one processor implements the method according to any one of the first aspect or the possible implementations of the first aspect.

Optionally, the memory refresh apparatus may further include at least one storage, and the at least one storage is configured to store the program code or the instructions.

According to a fourth aspect, an embodiment of this application further provides a chip, including an input interface, an output interface, and at least one processor. Optionally, the chip further includes a storage. The at least one processor is configured to execute code in the storage. When the at least one processor executes the code, the chip implements the method according to any one of the first aspect or the possible implementations of the first aspect.

Optionally, the chip may be an integrated circuit.

According to a fifth aspect, an embodiment of this application further provides a computer-readable storage medium, configured to store a computer program. The computer program includes a method for implementing any one of the first aspect or the possible implementations of the first aspect.

According to a sixth aspect, an embodiment of this application further provides a computer program product including instructions. When the computer program product runs on a computer, the computer is enabled to implement the method according to any one of the first aspect or the possible implementations of the first aspect.

The memory refresh apparatus, the computer storage medium, the computer program product, and the chip provided in embodiments are all configured to perform the method provided above. Therefore, for beneficial effects that can be achieved by the memory refresh apparatus, the computer storage medium, the computer program product, and the chip, refer to the beneficial effects of the method provided above. Details are not described herein again.

### BRIEF DESCRIPTION OF DRAWINGS

To describe technical solutions in embodiments of this application more clearly, the following briefly describes the accompanying drawings for describing the embodiments. It is clear that the accompanying drawings in the following descriptions are merely some of embodiments of this application, and a person of ordinary skill in the art may further derive other accompanying drawings from these accompanying drawings without creative efforts.
FIG. 1 is a diagram of a structure of a memory system according to an embodiment of this application;
FIG. 2 is a diagram of a structure of a memory chip according to an embodiment of this application;
FIG. 3 is a schematic flowchart of a memory refresh method according to an embodiment of this application;
FIG. 4 is a diagram of a memory refresh mode switching procedure according to an embodiment of this application;
FIG. 5 is a diagram of a structure of a memory refresh apparatus according to an embodiment of this application;
FIG. 6 is a diagram of a structure of a chip according to an embodiment of this application; and
FIG. 7 is a diagram of a structure of an electronic device according to an embodiment of this application.

### DESCRIPTION OF EMBODIMENTS

The following clearly and completely describes technical solutions of embodiments of this application with reference to the accompanying drawings in embodiments of this application. It is clear that the described embodiments are merely some but not all of embodiments of this application. All other embodiments obtained by a person of ordinary skill in the art based on embodiments of this application without creative efforts shall fall within the protection scope of embodiments of this application.

The term "and/or" in this specification describes only an association relationship between associated objects and indicates that there may be three relationships. For example, A and/or B may indicate the following three cases: Only A exists, both A and B exist, and only B exists.

In this specification and the accompanying drawings of embodiments of this application, the terms "first", "second", and the like are intended to distinguish between different objects or distinguish between different processing of a same object, but do not indicate a particular order of the objects.

In addition, the terms "including", "having", and any other variants thereof mentioned in descriptions of embodiments of this application are intended to cover a non-exclusive inclusion. For example, a process, a method, a system, a product, or a device that includes a series of steps or units is not limited to the listed steps or units, but optionally further includes another unlisted step or unit, or optionally further includes another inherent step or unit of the process, the method, the product, or the device.

It should be noted that, in descriptions of embodiments of this application, the word "example", "for example", or the like is used to represent giving an example, an illustration, or a description. Any embodiment or design scheme described as an "example" or "for example" in embodiments of this application should not be explained as being more preferred or having more advantages than another embodiment or design scheme. Exactly, use of the expression "example", "for example", or the like is intended to present a related concept in a specific manner.

In the descriptions of embodiments of this application, unless otherwise specified, "a plurality of" means two or more.

First, terms used in embodiments of this application are explained and described.

Bank (Bank): a name of a basic unit in a storage device. A bank includes a plurality of rows (Rows) and columns (Columns) to form a unit area.

Bank group (bank group, BG): A plurality of banks form a BG.

All bank refresh (All Bank Refresh, ABR): An entire rank is refreshed at a time. An overall refresh time is short and power consumption is low. However, all command lines are blocked at the same time, and performance is low.

Per bank refresh (Per Bank Refresh, PBR): Only one bank is refreshed at a time. All banks in a rank need to be refreshed in a polling mode. An overall refresh time is long and power consumption is high. However, when a specific bank is refreshed, command access to a bank that is not being refreshed is not affected, and performance is high.

Same bank refresh (Same Bank Refresh, SBR): Same banks in all BGs are refreshed at a time. All banks in an entire rank are refreshed in a polling mode. A quantity of banks refreshed at a time is between that in ABR and PBR, and performance is at the medium.

When an electronic device runs an application (application, APP), to-be-computed data needs to be transferred from a memory to a CPU for computation. When computation is completed, the CPU conveys a computation result.

In recent years, with an increase in functions of the app, computational data to be computed by the CPU also increases accordingly, and a data amount of memory swapping and power consumption of the memory also increase accordingly.

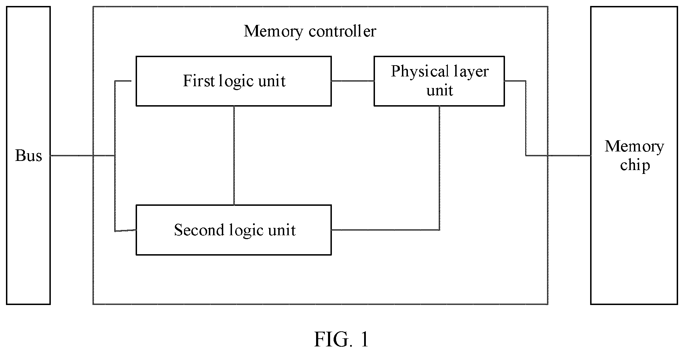

Therefore, an embodiment of this application provides a memory refresh method, to reduce power consumption of a memory. This method is applicable to a memory (Memory) system. FIG. 1 shows a possible existence form of the memory system.

As shown in FIG. 1, the memory system includes a memory chip, a memory controller, and a bus.

The memory controller includes a first logic unit, a second logic unit, and a physical layer unit.

The first logic unit is configured to: convert a double data rate synchronous dynamic random-access memory controller (a Double Data Rate Memory Controller, DMC) command into a command format of an off-chip particle, calculate a command sending time sequence of the particle, and complete another required function of a particle.

The second logic unit is configured to: obtain target information of a rank, and determine a memory refresh mode of the rank from a plurality of memory refresh modes based on the target information.

The physical layer unit is configured to: convert a digital signal into an analog signal, and connect to an off-chip storage device particle through an input/output interface.

The memory chip, namely, the off-chip storage device particle, is configured to: receive a command sent by the memory controller, store write data, and return read data.

The bus is configured to connect a CPU to the memory controller, and splice and forward commands of the CPU.

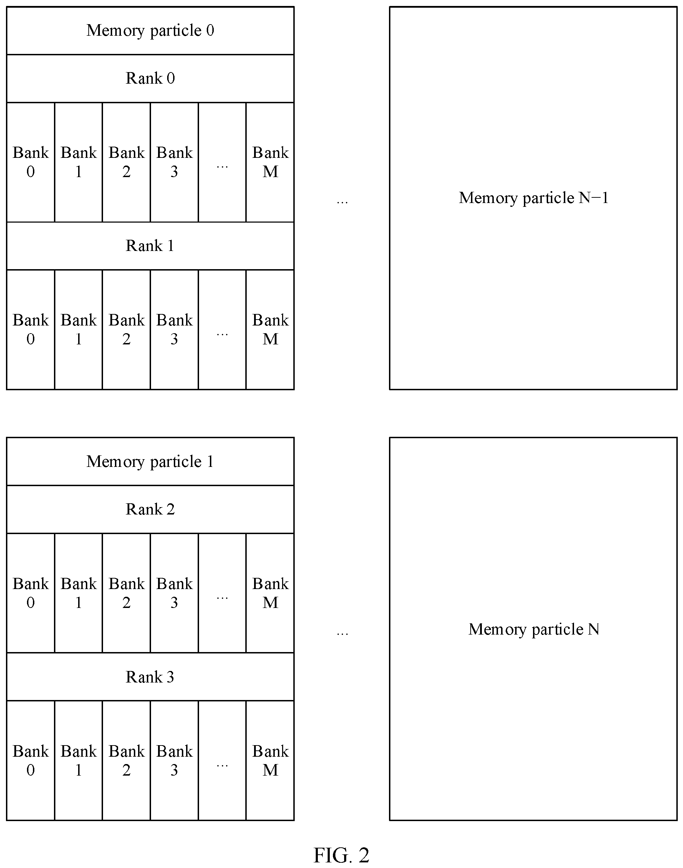

FIG. 2 shows a possible existence form of the foregoing memory chip. As shown in FIG. 2, the foregoing memory chip includes a plurality of memory particles. Each memory particle includes two ranks (Ranks) that share a group of commands and data cables, and each rank includes a plurality of banks (Banks). A plurality of banks may form a bank group.

The following describes the memory refresh method provided in this embodiment of this application with reference to the memory system shown in FIG. 1.

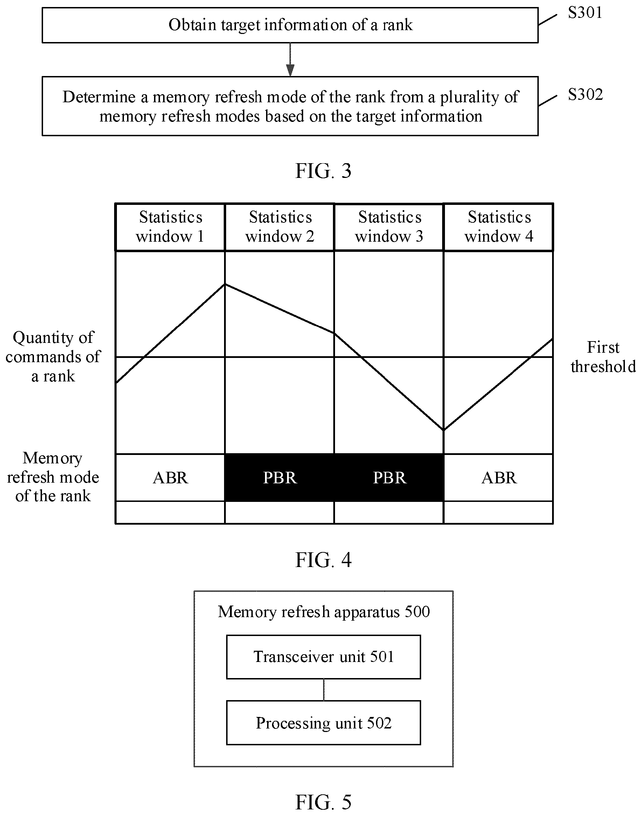

FIG. 3 shows a memory refresh method according to an embodiment of this application. The method may be performed by the memory controller in the foregoing memory system. As shown in FIG. 3, the method includes the following steps.

S301: The memory controller obtains target information of a rank.

The target information indicates a quantity of commands or traffic of the rank.

In a possible implementation, the quantity of commands includes at least one of a quantity of commands at an entry of the memory controller, a quantity of commands in a queue in the memory controller, or a quantity of commands on a memory interface.

For example, the target information of the rank may include the quantity of commands of the rank at the entry of the memory controller.

For another example, the target information of the rank may include the quantity of commands of the rank in the queue in the memory controller.

For still another example, the target information of the rank may include the quantity of commands of the rank on the memory interface.

In a possible implementation, the quantity of commands may be a quantity of all commands of the rank.

In another possible implementation, the quantity of commands may be a quantity of write commands of the rank.

In still another possible implementation, the quantity of commands may be a quantity of read commands of the rank.

In a possible implementation, the target information specifically indicates a quantity of commands or traffic of the rank in a period of time.

For example, the memory controller may obtain quantities of commands of a rank 1 and a rank 2 in a statistics window 1. Specific duration of a statistics window is not limited in embodiments of this application.

For example, the duration of the statistics window may be 2 µs, 4 µs, or 8 µs (microseconds).

In a possible implementation, a quantity of commands of the rank in the statistics window may be a quantity of commands of the rank obtained when the statistics window ends.

For example, the duration of the statistics window is 4 µs. In this case, the quantity of commands of the rank in the statistics window is a quantity of commands of the rank obtained when the statistics window is at a 4^{th} microsecond.

S302: The memory controller determines a memory refresh mode of the rank from a plurality of memory refresh modes based on the target information.

Power consumption of the rank varies in the plurality of memory refresh modes.

Optionally, the plurality of memory refresh modes may include a first memory refresh mode and a second memory refresh mode.

For example, the plurality of memory refresh modes may include an ABR mode and a PBR mode.

In a possible implementation, it may be determined, based on the target information, that the memory refresh mode of the rank is the first memory refresh mode or the second memory refresh mode.

For example, it may be determined, based on the quantity of commands of the rank at the entry of the memory controller, that the memory refresh mode of the rank is ABR or PBR.

It can be learned that, according to the memory refresh method provided in this embodiment of this application, the memory refresh mode of the rank can be dynamically switched between the first memory refresh mode and the second memory refresh mode that are with different power consumption based on the quantity of commands or the traffic of the rank. Compared with that in a related technology in which a memory is refreshed only in a high-power-consumption refresh mode, in the method provided in this embodiment of this application, a memory refresh mode of the memory is dynamically switched based on the quantity of commands or the traffic of the rank, so that power consumption of the memory can be reduced.

In a possible implementation, when the quantity of commands of the rank is greater than a first quantity threshold or the traffic is greater than a first traffic threshold, it may be determined that the memory refresh mode of the rank is the first memory refresh mode.

In a possible implementation, when the quantity of commands of the rank is less than the first quantity threshold or the traffic is less than the first traffic threshold, it may be determined that the memory refresh mode of the rank is the second memory refresh mode.

For example, as shown in FIG. 4, an initial memory refresh mode of the rank is ABR. Because a quantity of commands of the rank at an end of a statistics window 1 is greater than the first quantity threshold, the memory refresh mode of the rank is switched from ABR to PRB when a statistics window 2 starts. A quantity of commands of the rank at an end of the statistics window 2 is less than the quantity of commands of the rank at the end of the statistics window 1, but the quantity of commands of the rank at the end of the statistics window 2 is still greater than the first quantity threshold. Therefore, when a statistics window 3 starts, the memory refresh mode of the rank is not switched and is still maintained as PRB. A quantity of commands of the rank at an end of the statistics window 3 is less than the first quantity threshold. Therefore, when a statistics window 4 starts, the memory refresh mode of the rank is switched from PRB to ABR.

It may be understood that, if the quantity of commands of the rank is greater than the first quantity threshold or the traffic is greater than the first traffic threshold, it indicates that a data amount of memory swapping of the rank is large. Therefore, the memory refresh mode of the rank may be adjusted to the first memory refresh mode with higher power consumption, to improve memory swapping efficiency of the rank.

However, if the quantity of commands of the rank is less than the first quantity threshold or the traffic is less than the first traffic threshold, it indicates that a data amount of memory swapping of the rank is small. Therefore, the memory refresh mode of the rank may be adjusted to the second memory refresh mode with lower power consumption, to reduce the power consumption of the rank.

In a possible implementation, performance of the rank in the first memory refresh mode is higher than performance of the rank in the second memory refresh mode.

The performance of the rank includes at least memory bandwidth and a delay of the memory for a command.

For example, memory bandwidth of the rank in the first memory refresh mode is greater than memory bandwidth of the rank in the second memory refresh mode.

For another example, a delay of the rank for a command in the first memory refresh mode is lower than a delay of the rank for a command in the second memory refresh mode.

It can be learned that, according to the memory refresh method provided in this embodiment of this application, the memory refresh mode of the rank can be dynamically switched between the plurality of memory refresh modes with different performance based on the quantity of commands or the traffic of the rank. Compared with that in a related technology in which a memory is refreshed only in a low-performance memory refresh mode, in the method provided in this embodiment of this application, a memory refresh mode of the memory is dynamically switched based on the quantity of commands or the traffic of the rank, so that performance of the memory can be improved. Compared with that in a related technology in which the memory is refreshed only in a high-performance memory refresh mode, in the method provided in this embodiment of this application, the memory refresh mode of the memory is dynamically switched based on the quantity of commands or the traffic of the rank, so that power consumption of the memory can be reduced.

In a possible implementation, it may be determined, based on the target information, that the memory refresh mode of the rank is a first memory refresh mode, a second memory refresh mode, or a third memory refresh mode.

For example, it may be determined, based on the quantity of commands of the rank at the entry of the memory controller, that the memory refresh mode of the rank is ABR, PBR, or SBR.

It can be learned that, according to the memory refresh method provided in this embodiment of this application, the memory refresh mode of the rank can be dynamically switched among the first memory refresh mode, the second memory refresh mode, and the third memory refresh mode with different power consumption based on the quantity of commands or the traffic of the rank. Compared with that in a related technology in which a memory is refreshed only in a high-power-consumption refresh mode, in the method provided in this embodiment of this application, the memory refresh mode of the memory is dynamically switched based on the quantity of commands or the traffic of the rank, so that power consumption of the memory can be reduced.

Optionally, power consumption of the rank in the first memory refresh mode is higher than power consumption of the rank in the second memory refresh mode, and the power consumption of the rank in the second memory refresh mode is higher than power consumption of the rank in the third memory refresh mode.

In a possible implementation, when the quantity of commands of the rank is greater than a first quantity threshold or the traffic is greater than a first traffic threshold, it is determined that the memory refresh mode of the rank is the first memory refresh mode.

In a possible implementation, when the quantity of commands of the rank is less than the first quantity threshold and greater than a second quantity threshold, it is determined that the memory refresh mode of the rank is the second memory refresh mode.

In a possible implementation, when the traffic of the rank is less than the first traffic threshold and greater than a second traffic threshold, it is determined that the memory refresh mode of the rank is the second memory refresh mode.

In a possible implementation, when the quantity of commands of the rank is less than the second quantity threshold or the traffic is less than the second traffic threshold, it is determined that the memory refresh mode of the rank is the third memory refresh mode.

It may be understood that, if the quantity of commands of the rank is greater than the first quantity threshold or the traffic is greater than the first traffic threshold, it indicates that a data amount of memory swapping of the rank is large. Therefore, the memory refresh mode of the rank may be adjusted to the first memory refresh mode with higher power consumption, to improve memory swapping efficiency of the rank.

However, if the traffic of the rank is less than the first traffic threshold and greater than the second traffic threshold, or the traffic of the rank is less than the first traffic threshold and greater than the second traffic threshold, it indicates that a data amount of memory swapping of the rank is at a medium level. Therefore, the memory refresh mode of the rank may be adjusted to the second memory refresh mode with medium-level power consumption, to balance memory swapping efficiency and power consumption of the rank.

However, if the quantity of commands of the rank is less than the second quantity threshold or the traffic is less than the second traffic threshold, it indicates that a data amount of memory swapping of the rank is small. Therefore, the memory refresh mode of the rank may be adjusted to the third memory refresh mode with lower power consumption, to reduce the power consumption of the rank.

Optionally, performance of the rank in the first memory refresh mode is higher than performance of the rank in the second memory refresh mode, and the performance of the rank in the second memory refresh mode is higher than performance of the rank in the third memory refresh mode.

For example, memory bandwidth of the rank in the first memory refresh mode is greater than memory bandwidth of the rank in the second memory refresh mode. Memory bandwidth of the rank in the second memory refresh mode is greater than memory bandwidth of the rank in the third memory refresh mode.

For another example, a delay of the rank for a command in the first memory refresh mode is lower than a delay of the rank for a command in the second memory refresh mode. The delay of the rank for a command in the second memory refresh mode is less than a delay of the rank for a command in the third memory refresh mode.

It can be learned that, according to the memory refresh method provided in this embodiment of this application, the memory refresh mode of the rank can be dynamically switched between the plurality of memory refresh modes with different performance based on the quantity of commands or the traffic of the rank. Compared with that in a related technology in which a memory is refreshed only in a low-performance memory refresh mode, in the method provided in this embodiment of this application, a memory refresh mode of the memory is dynamically switched based on the quantity of commands or the traffic of the rank, so that performance of the memory can be improved. Compared with that in a related technology in which the memory is refreshed only in a high-performance memory refresh mode, in the method provided in this embodiment of this application, the memory refresh mode of the memory is dynamically switched based on the quantity of commands or the traffic of the rank, so that power consumption of the memory can be reduced.

Table 1 shows quantities of commands of two ranks that are collected in statistics windows during running of an electronic device. It can be learned from Table 1 that, a quantity of read commands, a quantity of write commands, and a total quantity of commands of a rank in different statistics windows are all constantly changing. However, in the memory refresh method provided in this embodiment of this application, the memory refresh mode of the rank can be dynamically switched between the plurality of memory refresh modes with different power consumption based on the quantity of commands or the traffic of the rank. Compared with that in a related technology in which a memory is refreshed only in a high-power-consumption refresh mode, in the method provided in this embodiment of this application, a memory refresh mode of the memory is dynamically switched based on the quantity of commands or the traffic of the rank, so that power consumption of the memory can be reduced.

It can be learned from Table 1 that, in a same statistics window, quantities of read commands, quantities of write commands, and total quantities of commands of a rank 0 and a rank 1 are mostly different. Therefore, in a same statistics period, the rank 0 and the rank 1 may switch to different memory refresh modes due to different quantities of read commands, quantities of write commands, and total quantities of commands. In other words, memory refresh modes of the rank 0 and the rank 1 are independent. For example, at a same moment, the memory mode of the rank 0 is ABR, and the memory mode of the rank 1 is PBR.

Certainly, a memory refresh mode of a plurality of ranks may alternatively be determined based on a sum of quantities of commands or an average value of quantities of commands of the plurality of ranks in a same memory particle, so that the plurality of ranks in the same memory particle switch to a same memory refresh mode.

For example, a memory particle 0 includes a rank 0 and a rank 1, and the memory controller may determine a memory refresh mode of the rank 0 and the rank 1 based on a sum of a quantity of commands of the rank 0 and a quantity of commands of the rank 1.

For another example, a memory particle 1 includes a rank 2 and a rank 3, and the memory controller may determine a memory refresh mode of the rank 2 and the rank 3 based on an average value of a quantity of commands of the rank 2 and a quantity of commands of the rank 3.

**Table 1**

| | Quantity of read commands of rank 0 | Quantity of write commands of rank 0 | Total quantity of commands of rank 0 | Quantity of read commands of rank 1 | Quantity of write commands of rank 1 | Total quantity of commands of rank 1 |
|---|---|---|---|---|---|---|
| Statistics window 1 | 3188 | 660 | 3848 | 1479 | 186 | 1665 |
| Statistics window 2 | 1412 | 780 | 2192 | 226 | 74 | 300 |
| Statistics window 3 | 836 | 689 | 1525 | 536 | 111 | 647 |
| Statistics window 4 | 3024 | 754 | 3778 | 825 | 302 | 1127 |
| Statistics window 5 | 3031 | 846 | 3877 | 577 | 248 | 825 |
| Statistics window 6 | 8455 | 1854 | 10309 | 1496 | 965 | 2461 |
| Statistics window 7 | 10566 | 1489 | 12055 | 6122 | 2163 | 8285 |
| Statistics window 8 | 6060 | 1408 | 7468 | 1903 | 1589 | 3492 |
| Statistics window 9 | 3566 | 562 | 4128 | 394 | 494 | 888 |
| Statistics window 10 | 3825 | 927 | 4752 | 1124 | 547 | 1671 |
| Statistics window 11 | 5819 | 893 | 6712 | 1008 | 531 | 1539 |
| Statistics window 12 | 4131 | 1028 | 5159 | 1714 | 545 | 2259 |
| Statistics window 13 | 2088 | 3071 | 5159 | 560 | 2685 | 3245 |
| Statistics window 14 | 0 | 0 | 0 | 0 | 0 | 0 |
| Statistics window 15 | 21 | 50 | 71 | 7 | 0 | 7 |
| Statistics window 16 | 67 | 85 | 152 | 41 | 9 | 50 |
| Statistics window 17 | 1873 | 4996 | 6869 | 1585 | 1217 | 2802 |
| Statistics window 18 | 5244 | 5979 | 11223 | 5635 | 1102 | 6737 |

The following describes a memory refresh apparatus configured to execute the foregoing memory refresh method with reference to FIG. 5.

It may be understood that, to implement the foregoing functions, the memory refresh apparatus includes corresponding hardware and/or software modules for performing the functions. With reference to the example algorithm steps described in embodiments disclosed in this specification, embodiments of this application can be implemented in a form of hardware or combination of hardware and computer software. Whether a function is performed by hardware or hardware driven by computer software depends on particular applications and design constraints of the technical solutions. A person skilled in the art may use different methods to implement the described functions for each particular application with reference to the embodiments, but it should not be considered that the implementation goes beyond the scope of embodiments of this application.

In embodiments of this application, the memory refresh apparatus may be divided into functional modules based on the foregoing method examples. For example, each functional module may be obtained through division based on each corresponding function, or two or more functions may be integrated into one processing module. The integrated module may be implemented in a form of hardware. It should be noted that, in this embodiment, division into the modules is an example, and is merely logical function division. During actual implementation, another division manner may be used.

When each functional module is obtained through division based on each corresponding function, FIG. 5 is a possible diagram of composition of the memory refresh apparatus in the foregoing embodiment. As shown in FIG. 5, the memory refresh apparatus 500 may include a transceiver unit 501 and a processing unit 502.

The transceiver unit 501 is configured to obtain target information of a rank, and the target information indicates a quantity of commands or traffic of the rank.

The processing unit 502 is configured to determine a memory refresh mode of the rank from a plurality of memory refresh modes based on the target information, and power consumption of the rank in the plurality of memory refresh modes is different.

Optionally, the quantity of commands includes at least one of a quantity of commands at an entry of a memory controller, a quantity of commands in a queue in the memory controller, or a quantity of commands on a memory interface.

Optionally, the plurality of memory refresh modes include a first memory refresh mode and a second memory refresh mode.

In a possible implementation, the processing unit is specifically configured to determine, based on the target information, that the memory refresh mode of the rank is the first memory refresh mode or the second memory refresh mode.

Optionally, power consumption of the rank in the first memory refresh mode is higher than power consumption of the rank in the second memory refresh mode.

In a possible implementation, the processing unit is specifically configured to: when the quantity of commands of the rank is greater than a first quantity threshold or the traffic is greater than a first traffic threshold, determine that the memory refresh mode of the rank is the first memory refresh mode; or when the quantity of commands of the rank is less than the first quantity threshold or the traffic is less than the first traffic threshold, determine that the memory refresh mode of the rank is the second memory refresh mode.

Optionally, performance of the rank in the first memory refresh mode is higher than performance of the rank in the second memory refresh mode.

Optionally, the plurality of memory refresh modes include a first memory refresh mode, a second memory refresh mode, and a third memory refresh mode.

In a possible implementation, the processing unit is specifically configured to determine, based on the target information, that the memory refresh mode of the rank is the first memory refresh mode, the second memory refresh mode, or the third memory refresh mode.

Optionally, power consumption of the rank in the first memory refresh mode is higher than power consumption of the rank in the second memory refresh mode, and the power consumption of the rank in the second memory refresh mode is higher than power consumption of the rank in the third memory refresh mode.

In a possible implementation, when the quantity of commands of the rank is greater than a first quantity threshold or the traffic is greater than a first traffic threshold, it is determined that the memory refresh mode of the rank is the first memory refresh mode. When the quantity of commands of the rank is less than the first quantity threshold and greater than a second quantity threshold, it is determined that the memory refresh mode of the rank is the second memory refresh mode. When the traffic of the rank is less than the first traffic threshold and greater than a second traffic threshold, it is determined that the memory refresh mode of the rank is the second memory refresh mode. When the quantity of commands of the rank is less than the second quantity threshold or the traffic is less than the second traffic threshold, it is determined that the memory refresh mode of the rank is the third memory refresh mode.

Optionally, performance of the rank in the first memory refresh mode is higher than performance of the rank in the second memory refresh mode, and the performance of the rank in the second memory refresh mode is higher than performance of the rank in the third memory refresh mode.

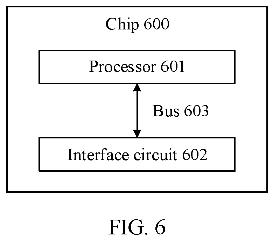

An embodiment of this application further provides a chip. FIG. 6 is a diagram of a structure of a chip 600. The chip 600 includes one or more processors 601 and an interface circuit 602. Optionally, the chip 600 may further include a bus 603.

The processor 601 may be an integrated circuit chip and has a signal processing capability. In an implementation process, the steps of the foregoing packet processing method may be completed by using an integrated logic circuit of hardware in the processor 601 or by using instructions in a form of software.

Optionally, the processor 601 may be a general-purpose processor, a digital signal processor (digital signal processing, DSP), an application-specific integrated circuit (application-specific integrated circuit, ASIC), a field-programmable gate array (field-programmable gate array, FPGA) or another programmable logic device, a discrete gate or a transistor logic device, or a discrete hardware component. The processor 601 may implement or perform the methods and steps disclosed in embodiments of this application. The general-purpose processor may be a microprocessor, or the processor may be any conventional processor or the like.

The interface circuit 602 may be configured to send or receive data, instructions, or information. The processor 601 may process the data, the instructions, or other information received through the interface circuit 602, and may send processed information through the interface circuit 602.

Optionally, the chip further includes a storage. The storage may include a read-only memory and a random-access memory, and provide operation instructions and data for the processor. A part of the storage may further include a non-volatile random-access memory (non-volatile random-access memory, NVRAM).

Optionally, the storage stores an executable software module or a data structure, and the processor may perform a corresponding operation by invoking operation instructions stored in the storage (the operation instructions may be stored in an operating system).

Optionally, the chip may be used in the memory refresh apparatus in embodiments of this application. Optionally, the interface circuit 602 may be configured to output an execution result of the processor 601. For the packet processing method provided in one or more embodiments of this application, refer to the foregoing embodiments. Details are not described herein again.

It should be noted that functions corresponding to the processor 601 and the interface circuit 602 may be implemented by using a hardware design, may be implemented by using a software design, or may be implemented by using a combination of software and hardware. This is not limited herein.

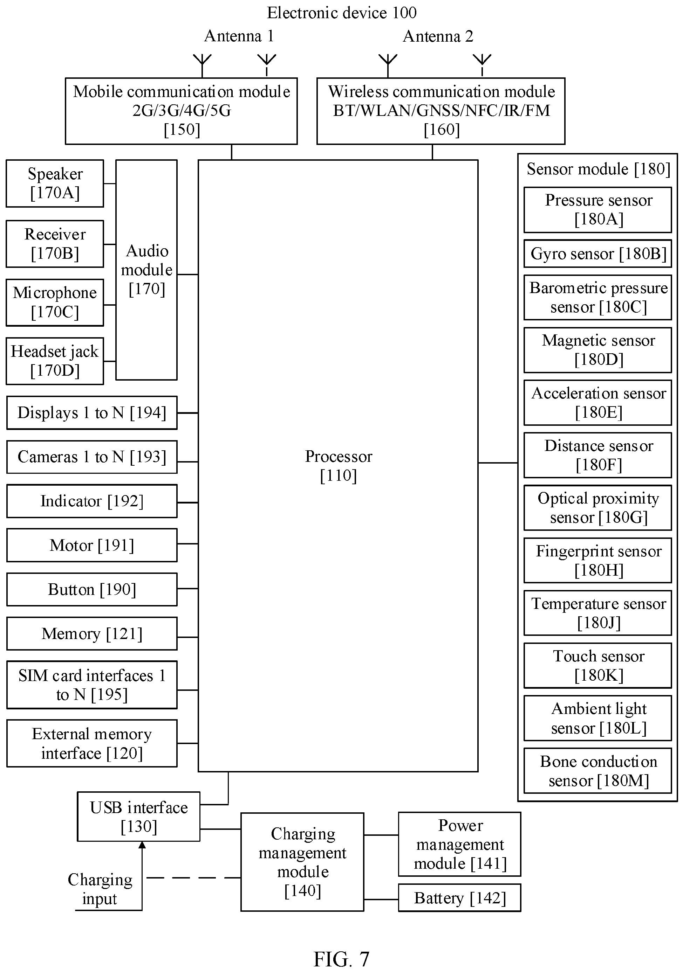

FIG. 7 is a diagram of a structure of an electronic device according to an embodiment of this application. The electronic device 100 may be a mobile phone, a tablet computer, a wearable device, a vehicle-mounted device, an augmented reality (augmented reality, AR)/virtual reality (virtual reality, VR) device, a notebook computer, an ultra-mobile personal computer (ultra-mobile personal computer, UMPC), a netbook, a personal digital assistant (personal digital assistant, PDA), a memory refresh apparatus, or a chip or a functional module in a memory refresh apparatus.

For example, FIG. 7 is a diagram of a structure of the electronic device 100 according to an embodiment of this application. The electronic device 100 may include a processor 110, an external memory interface 120, a memory 121, a universal serial bus (universal serial bus, USB) interface 130, a charging management module 140, a power management module 141, a battery 142, an antenna 1, an antenna 2, a mobile communication module 150, a wireless communication module 160, an audio module 170, a speaker 170A, a receiver 170B, a microphone 170C, a headset jack 170D, a sensor module 180, a button 190, a motor 191, an indicator 192, a camera 193, a display 194, a subscriber identity module (subscriber identity module, SIM) card interface 195, and the like. The sensor module 180 may include a pressure sensor 180A, a gyro sensor 180B, a barometric pressure sensor 180C, a magnetic sensor 180D, an acceleration sensor 180E, a distance sensor 180F, an optical proximity sensor 180G, a fingerprint sensor 180H, a temperature sensor 180J, a touch sensor 180K, an ambient light sensor 180L, a bone conduction sensor 180M, and the like.

It may be understood that the structure shown in this embodiment of this application does not constitute a specific limitation on the electronic device 100. In some other embodiments of this application, the electronic device 100 may include more or fewer components than those shown in the figure, or combine some components, or split some components, or have a different component arrangement. The components shown in the figure may be implemented by hardware, software, or a combination of software and hardware.

The processor 110 may include one or more processing units. For example, the processor 110 may include an application processor (application processor, AP), a modem processor, a graphics processing unit (graphics processing unit, GPU), an image signal processor (image signal processor, ISP), a controller, a storage, a video codec, a digital signal processor (digital signal processor, DSP), a baseband processor, a neural-network processing unit (neural-network processing unit, NPU), and/or the like. Different processing units may be independent components, or may be integrated into one or more processors.

The controller may be a nerve center and a command center of the electronic device 100. The controller may generate an operation control signal based on an instruction operation code and a time sequence signal, to complete control of instruction fetching and instruction execution.

A storage may be further disposed in the processor 110, and is configured to store instructions and data. In some embodiments, the processor 110 may include one or more interfaces. The interface may include an inter-integrated circuit (inter-integrated circuit, I2C) interface, an inter-integrated circuit sound (inter-integrated circuit sound, I2S) interface, a pulse code modulation (pulse code modulation, PCM) interface, a universal asynchronous receiver/transmitter (universal asynchronous receiver/transmitter, UART) interface, a mobile industry processor interface (mobile industry processor interface, MIPI), a general-purpose input/output (general-purpose input/output, GPIO) interface, a subscriber identity module (subscriber identity module, SIM) interface, a universal serial bus (universal serial bus, USB) interface, and/or the like.

The I2C interface is a bidirectional synchronous serial bus. The processor 110 may be coupled to the touch sensor 180K through the I2C interface, so that the processor 110 communicates with the touch sensor 180K through the I2C bus interface, to implement a touch function of the electronic device 100. The MIPI may be configured to connect the processor 110 to a peripheral component like the display 194 or the camera 193. The MIPI includes a camera serial interface (camera serial interface, CSI), a display serial interface (display serial interface, DSI), and the like. In some embodiments, the processor 110 communicates with the camera 193 through the CSI, to implement a photographing function of the electronic device 100. The processor 110 communicates with the display 194 through the DSI, to implement a display function of the electronic device 100.

It may be understood that an interface connection relationship between the modules illustrated in embodiments of this application is merely an example for description, and does not constitute a limitation on the structure of the electronic device 100. In some other embodiments of this application, the electronic device 100 may alternatively use an interface connection manner different from that in the foregoing embodiment, or use a combination of a plurality of interface connection manners.

The charging management module 140 is configured to receive a charging input from a charger. The charger may be a wireless charger or a wired charger. The power management module 141 is configured to connect to the battery 142, the charging management module 140, and the processor 110. The power management module 141 receives an input from the battery 142 and/or the charging management module 140, to supply power to the processor 110, the memory 121, an external memory, the display 194, the camera 193, the wireless communication module 160, and the like.

The electronic device 100 implements the display function by using the GPU, the display 194, the application processor, and the like. The GPU is a microprocessor for image processing, and is connected to the display 194 and the application processor. The GPU is configured to: perform mathematical and geometric computation, and render an image. The processor 110 may include one or more GPUs, which execute program instructions to generate or change display information.

The display 194 is configured to display an image, a video, and the like. The display 194 includes a display panel. The display panel may be a liquid crystal display (liquid crystal display, LCD), an organic light-emitting diode (organic light-emitting diode, OLED), an active-matrix organic light-emitting diode (active-matrix organic light-emitting diode, AMOLED), a flexible light-emitting diode (flexible light-emitting diode, FLED), a mini-LED, a micro-LED, a micro-OLED, a quantum dot light-emitting diode (quantum dot light-emitting diode, QLED), or the like. In some embodiments, the electronic device 100 may include one or N displays 194, where N is a positive integer greater than 1.

The electronic device 100 may implement the photographing function by using the ISP, the camera 193, the touch sensor, the video codec, the GPU, the display 194, the application processor, and the like.

The ISP is configured to process data fed back by the camera 193. For example, during photographing, a shutter is pressed, and light is transmitted to a photosensitive element of the camera through a lens. An optical signal is converted into an electrical signal, and the photosensitive element of the camera transmits the electrical signal to the ISP for processing, to convert the electrical signal into a visible image. The ISP may further perform algorithm optimization on noise, brightness, and complexion of the image. The ISP may further optimize parameters such as exposure and a color temperature of a photographing scenario. In some embodiments, the ISP may be disposed in the camera 193.

The camera 193 is configured to capture a static image or a video. An optical image of an object is generated through the lens, and is projected onto the photosensitive element. The photosensitive element may be a charge-coupled device (charge-coupled device, CCD) or a complementary metal-oxide-semiconductor (complementary metal-oxide-semiconductor, CMOS) phototransistor. The photosensitive element converts an optical signal into an electrical signal, and then transmits the electrical signal to the ISP to convert the electrical signal into a digital image signal. The ISP outputs the digital image signal to the DSP for processing. The DSP converts the digital image signal into an image signal in a standard format, for example, RGB or YUV It should be understood that, in descriptions of embodiments of this application, an image in an RGB format is used as an example for description. An image format is not limited in embodiments of this application. In some embodiments, the electronic device 100 may include one or N cameras 193, where N is a positive integer greater than 1.

The digital signal processor is configured to process a digital signal, and may further process another digital signal in addition to the digital image signal. For example, when the electronic device 100 selects a frequency, the digital signal processor is configured to perform Fourier transformation on frequency energy.

The video codec is configured to compress or decompress a digital video. The electronic device 100 may support one or more video codecs. In this way, the electronic device 100 may play or record videos in a plurality of coding formats, for example, moving picture experts group (moving picture experts group, MPEG)-1, MPEG-2, MPEG-3, and MPEG-4.

The external memory interface 120 may be configured to connect an external memory card, for example, a micro SD card, to expand a storage capability of the electronic device 100. The memory 121 may be configured to store computer-executable program code. The executable program code includes instructions. The processor 110 runs the instructions stored in the memory 121, to perform various function applications of the electronic device 100 and data processing. The memory 121 may include a program storage area and a data storage area.

The electronic device 100 may implement an audio function, for example, music playing and recording, through the audio module 170, the speaker 170A, the receiver 170B, the microphone 170C, the headset jack 170D, the application processor, and the like.

The button 190 includes a power button, a volume button, and the like. The button 190 may be a mechanical button, or may be a touch button. The electronic device 100 may receive a key input, and generate a key signal input related to a user setting and function control of the electronic device 100. The motor 191 may generate a vibration prompt. The motor 191 may be configured to provide an incoming call vibration prompt and a touch vibration feedback. For example, touch operations performed on different applications (for example, photographing and audio playing) may correspond to different vibration feedback effects. The motor 191 may also correspond to different vibration feedback effects for touch operations performed in different areas of the display 194. The indicator 192 may be an indicator light, and may be configured to indicate a charging status and a power change, or may be configured to indicate a message, a missed call, a notification, and the like. The SIM card interface 195 is configured to connect to a SIM card.

It should be noted that the electronic device 100 may be a chip system or a device having a structure similar to that in FIG. 7. The chip system may include a chip, or may include a chip and another discrete device. Actions, terms, and the like in embodiments of this application may be mutually referenced. This is not limited. In embodiments of this application, names of messages exchanged between devices, names of parameters in the messages, or the like are merely examples. Other names may alternatively be used during specific implementation. This is not limited. In addition, the composition structure shown in FIG. 7 does not constitute a limitation on the electronic device 100. In addition to the components shown in FIG. 7, the electronic device 100 may include more or fewer components than those shown in FIG. 7, or combine some components, or have a different component arrangement.

The processor and the transceiver described in this application may be implemented on an integrated circuit (integrated circuit, IC), an analog IC, a radio frequency integrated circuit, a mixed signal IC, an application-specific integrated circuit (application-specific integrated circuit, ASIC), a printed circuit board (printed circuit board, PCB), an electronic device, or the like. The processor and the transceiver may alternatively be manufactured by using various IC process technologies, for example, a complementary metal oxide semiconductor (complementary metal oxide semiconductor, CMOS), an n-type metal oxide semiconductor (n-type metal oxide semiconductor, NMOS), a P-type metal oxide semiconductor (positive channel metal oxide semiconductor, PMOS), a bipolar junction transistor (Bipolar Junction Transistor, BJT), a bipolar CMOS (BiCMOS), silicon germanium (SiGe), and gallium arsenide (GaAs).

An embodiment of this application further provides a memory refresh apparatus. The apparatus includes at least one processor. When the at least one processor executes program code or instructions, the foregoing related method steps are implemented to implement the packet processing method in the foregoing embodiments.

Optionally, the apparatus may further include at least one storage, and the at least one storage is configured to store the program code or the instructions.

An embodiment of this application further provides a computer storage medium. The computer storage medium stores computer instructions. When the computer instructions are run on a memory refresh apparatus, the memory refresh apparatus is enabled to perform the foregoing related method steps to implement the packet processing method in the foregoing embodiments.

An embodiment of this application further provides a computer program product. When the computer program product runs on a computer, the computer is enabled to perform the foregoing related steps to implement the packet processing method in the foregoing embodiments.

An embodiment of this application further provides a memory refresh apparatus. The apparatus may be specifically a chip, an integrated circuit, a component, or a module. Specifically, the apparatus may include a connected processor and a storage configured to store instructions, or the apparatus includes at least one processor, configured to obtain instructions from an external memory. When the apparatus runs, the processor may execute the instructions, so that the chip performs the packet processing method in the foregoing method embodiments.

It should be understood that sequence numbers of the foregoing processes do not mean execution sequences in various embodiments of this application. The execution sequences of the processes should be determined based on functions and internal logic of the processes, and should not constitute any limitation on the implementation processes of embodiments of this application.

A person of ordinary skill in the art may be aware that, in combination with the examples described in embodiments disclosed in this specification, units and algorithm steps may be implemented by electronic hardware or a combination of computer software and electronic hardware. Whether these functions are performed by hardware or software depends on particular applications and design constraints of the technical solutions. A person skilled in the art may use different methods to implement the described functions for each particular application, but it should not be considered that the implementation goes beyond the scope of this application.

It may be clearly understood by a person skilled in the art that, for the purpose of convenient and brief description, for a detailed working process of the foregoing system, apparatus, and unit, refer to a corresponding process in the foregoing method embodiments. Details are not described herein again.

In the several embodiments provided in this application, it should be understood that the disclosed system, apparatus, and method may be implemented in other manners. For example, the described apparatus embodiment is merely an example. For example, division into the units is merely logical function division and may be other division during actual implementation. For example, a plurality of units or components may be combined or integrated into another system, or some features may be ignored or not performed. In addition, the displayed or discussed mutual couplings or direct couplings or communication connections may be implemented through some interfaces. The indirect couplings or communication connections between the apparatuses or units may be implemented in electrical, mechanical, or other forms.

The foregoing units described as separate components may or may not be physically separate, and components displayed as units may or may not be physical units, may be located in one position, or may be distributed on a plurality of network units. Some or all of the units may be selected according to actual requirements to achieve the objectives of the solutions of embodiments.

In addition, functional units in embodiments of this application may be integrated into one processing unit, or each of the units may exist alone physically, or two or more units are integrated into one unit.

When the functions are implemented in a form of software functional unit and sold or used as an independent product, the functions may be stored in a computer-readable storage medium. Based on such an understanding, the technical solutions of this application essentially, or the part contributing to the conventional technology, or some of the technical solutions may be implemented in a form of software product. The computer software product is stored in a storage medium, and includes several instructions for instructing a computer device (which may be a personal computer, a server, or a network device) to perform all or some of the steps of the methods described in embodiments of this application. The storage medium includes any medium that can store program code, such as a USB flash drive, a removable hard disk drive, a read-only memory (Read-Only Memory, ROM), a random-access memory (Random-Access Memory, RAM), a magnetic disk, or an optical disc.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A memory refresh method, comprising:
obtaining target information of a rank, wherein the target information indicates a quantity of commands or traffic of the rank; and
determining a memory refresh mode of the rank from a plurality of memory refresh modes based on the target information, wherein power consumption of the rank varies in the plurality of memory refresh modes.

2. The method according to claim 1, wherein the quantity of commands comprises at least one of a quantity of commands at an entry of a memory controller, a quantity of commands in a queue in the memory controller, or a quantity of commands on a memory interface.

3. The method according to claim 1 or 2, wherein the plurality of memory refresh modes comprise a first memory refresh mode and a second memory refresh mode, and the determining a memory refresh mode of the rank from a plurality of memory refresh modes based on the target information comprises:
determining, based on the target information, that the memory refresh mode of the rank is the first memory refresh mode or the second memory refresh mode.

4. The method according to claim 3, wherein power consumption of the rank in the first memory refresh mode is higher than power consumption of the rank in the second memory refresh mode, and the determining, based on the target information, that the memory refresh mode of the rank is the first memory refresh mode or the second memory refresh mode comprises:
when the quantity of commands of the rank is greater than a first quantity threshold or the traffic is greater than a first traffic threshold, determining that the memory refresh mode of the rank is the first memory refresh mode; or
when the quantity of commands of the rank is less than the first quantity threshold or the traffic is less than the first traffic threshold, determining that the memory refresh mode of the rank is the second memory refresh mode.

5. The method according to claim 3 or 4, wherein performance of the rank in the first memory refresh mode is higher than performance of the rank in the second memory refresh mode.

6. The method according to claim 1 or 2, wherein the plurality of memory refresh modes comprise a first memory refresh mode, a second memory refresh mode, and a third memory refresh mode, and the determining a memory refresh mode of the rank from a plurality of memory refresh modes based on the target information comprises:
determining, based on the target information, that the memory refresh mode of the rank is the first memory refresh mode, the second memory refresh mode, or the third memory refresh mode.

7. The method according to claim 6, wherein power consumption of the rank in the first memory refresh mode is higher than power consumption of the rank in the second memory refresh mode, the power consumption of the rank in the second memory refresh mode is higher than power consumption of the rank in the third memory refresh mode, and the determining, based on the target information, that the memory refresh mode of the rank is the first memory refresh mode, the second memory refresh mode, or the third memory refresh mode comprises:
when the quantity of commands of the rank is greater than a first quantity threshold or the traffic is greater than a first traffic threshold, determining that the memory refresh mode of the rank is the first memory refresh mode;
when the quantity of commands of the rank is less than the first quantity threshold and greater than a second quantity threshold, determining that the memory refresh mode of the rank is the second memory refresh mode;
when the traffic of the rank is less than the first traffic threshold and greater than a second traffic threshold, determining that the memory refresh mode of the rank is the second memory refresh mode; or
when the quantity of commands of the rank is less than the second quantity threshold or the traffic is less than the second traffic threshold, determining that the memory refresh mode of the rank is the third memory refresh mode.

8. The method according to claim 6 or 7, wherein performance of the rank in the first memory refresh mode is higher than performance of the rank in the second memory refresh mode, and the performance of the rank in the second memory refresh mode is higher than performance of the rank in the third memory refresh mode.

9. A memory refresh apparatus, comprising a transceiver unit and a processing unit, wherein
the transceiver unit is configured to obtain target information of a rank, wherein the target information indicates a quantity of commands or traffic of the rank; and
the processing unit is configured to determine a memory refresh mode of the rank from a plurality of memory refresh modes based on the target information, wherein power consumption of the rank varies in the plurality of memory refresh modes.

10. The apparatus according to claim 9, wherein the quantity of commands comprises at least one of a quantity of commands at an entry of a memory controller, a quantity of commands in the queue in the memory controller, or a quantity of commands on a memory interface.

11. The apparatus according to claim 9 or 10, wherein the plurality of memory refresh modes comprise a first memory refresh mode and a second memory refresh mode, and the processing unit is specifically configured to:
determine, based on the target information, that the memory refresh mode of the rank is the first memory refresh mode or the second memory refresh mode.

12. The apparatus according to claim 11, wherein power consumption of the rank in the first memory refresh mode is higher than power consumption of the rank in the second memory refresh mode, and the processing unit is specifically configured to:
when the quantity of commands of the rank is greater than a first quantity threshold or the traffic is greater than a first traffic threshold, determine that the memory refresh mode of the rank is the first memory refresh mode; or
when the quantity of commands of the rank is less than the first quantity threshold or the traffic is less than the first traffic threshold, determine that the memory refresh mode of the rank is the second memory refresh mode.

13. The apparatus according to claim 11 or 12, wherein performance of the rank in the first memory refresh mode is higher than performance of the rank in the second memory refresh mode.

14. The apparatus according to claim 9 or 10, wherein the plurality of memory refresh modes comprise a first memory refresh mode, a second memory refresh mode, and a third memory refresh mode, and the processing unit is specifically configured to:
determine, based on the target information, that the memory refresh mode of the rank is the first memory refresh mode, the second memory refresh mode, or the third memory refresh mode.

15. The apparatus according to claim 14, wherein power consumption of the rank in the first memory refresh mode is higher than power consumption of the rank in the second memory refresh mode, the power consumption of the rank in the second memory refresh mode is higher than power consumption of the rank in the third memory refresh mode, and the processing unit is specifically configured to:
when the quantity of commands of the rank is greater than a first quantity threshold or the traffic is greater than a first traffic threshold, determine that the memory refresh mode of the rank is the first memory refresh mode;
when the quantity of commands of the rank is less than the first quantity threshold and greater than a second quantity threshold, determine that the memory refresh mode of the rank is the second memory refresh mode;
when the traffic of the rank is less than the first traffic threshold and greater than a second traffic threshold, determine that the memory refresh mode of the rank is the second memory refresh mode; or
when the quantity of commands of the rank is less than the second quantity threshold or the traffic is less than the second traffic threshold, determine that the memory refresh mode of the rank is the third memory refresh mode.

16. The apparatus according to claim 14 or 15, wherein performance of the rank in the first memory refresh mode is higher than performance of the rank in the second memory refresh mode, and the performance of the rank in the second memory refresh mode is higher than performance of the rank in the third memory refresh mode.

17. A memory refresh apparatus, comprising at least one processor and a storage, wherein the at least one processor executes a program or instructions stored in the storage, so that the memory refresh apparatus implements the method according to any one of claims 1 to 8.

18. A computer-readable storage medium, configured to store a computer program, wherein when the computer program is run on a computer or a processor, the computer or the processor is enabled to implement the method according to any one of claims 1 to 8.

19. A computer program product, wherein the computer program product comprises instructions, and when the instructions are run on a computer or a processor, the computer or the processor is enabled to implement the method according to any one of claims 1 to 8.
